# EUROPÄISCHE PATENTSCHRIFT

(11) **EP 4 049 823 B1**
(45) Veröffentlichungstag und Bekanntmachung des Hinweises auf die Patenterteilung: **20.11.2024**
(21) Anmeldenummer: 22156762.1
(22) Anmeldetag: 15.02.2022
(51) Int. Cl.: B29C 45/14, H05K 5/02, H05K 7/20, B29L 31/34

(54) **LEISTUNGSELEKTRONIK-BAUTEIL MIT EINEM SPRITZGUSSGEHÄUSE UND VERFAHREN ZUM HERSTELLEN EINES SPRITZGUSSGEHÄUSES**
POWER ELECTRONICS COMPONENT WITH AN INJECTION MOULDED HOUSING AND METHOD FOR PRODUCING AN INJECTION MOULDED HOUSING
COMPOSANT ÉLECTRONIQUE DE PUISSANCE DOTÉ D'UN BOÎTIER MOULÉ PAR INJECTION ET PROCÉDÉ DE FABRICATION D'UN BOÎTIER MOULÉ PAR INJECTION

(30) Priorität: 24.02.2021 DE 102021104390
(43) Veröffentlichungstag der Anmeldung: 31.08.2022
(73) Patentinhaber: Scherdel Innotec Forschungs- Und Entwicklungs GmbH, 95615 Marktredwitz (DE)
(72) Erfinder: DIETRICH, Swen, 95615 Marktredwitz (DE); THUMSER, Marco, 95615 Marktredwitz (DE)
(74) Vertreter: Schmitt-Nilson Schraud Waibel Wohlfrom Patentanwälte Partnerschaft mbB

(56) Entgegenhaltungen:
- JP-A- 2004 356 555
- US-A1- 2006 196 050
- US-B2- 10 925 181

## Beschreibung

Die Erfindung betrifft ein Leistungselektronik-Bauteil eines elektrifizierten Antriebsstrangs eines Elektromotor-, Hybridmotor- oder Brennstoffzellen-Fahrzeugs, das als DC/DC-Wandler eines Elektromotor-, Hybridmotor- oder Brennstoffzellen-Fahrzeugs ausgebildet ist, mit einem Spritzgussgehäuse sowie ein Verfahren zum Herstellen eines solchen Spritzgussgehäuses.

Leistungselektronik-Bauteile, wie sie bei einem elektrifizierten Antriebsstrang eines Elektromotor-, Hybridmotor- oder Brennstoffzellen-Fahrzeugs zum Einsatz kommen müssen zum Schutz vor Einflüssen oder Einwirkungen von außen durch ein Gehäuse umgeben werden. Gleichzeitig muss die Wärme, die durch das Leistungselektronik-Bauteil entsteht, effektiv abgeleitet werden.

Hierfür kommen derzeit häufig Aluminiumdruckgussgehäuse zum Einsatz. Diese sind jedoch teuer in der Herstellung und relativ schwer, was das Gesamtgewicht des Fahrzeugs erhöht, was unerwünscht ist.

Aus der US 10,925,181 B2 ist ein Leistungselektronik-Bauteil eines elektrifizierten Antriebsstrangs eines Hybridmotor-Fahrzeugs mit den Merkmalen des Oberbegriffs des unabhängigen Patentanspruchs 1 bekannt.

Die JP 2004 356 555 A zeigt ein Wärme erzeugendes Element, z.B. ein Halbleiterelement eines Elektronikbauteils, und ein Wärme aufnehmendes Element, das aus gepressten und gesinterten metallischen Pulvern hergestellt wird.

Aus der US 2006/196050 A1 ist eine Kühleinheit mit zwei flachen tafelförmigen Elementen und einem Kühlrohr bekannt, die ein lichtdurchlässiges optisches Element randseitig umschließt.

Es ist daher eine Aufgabe der vorliegenden Erfindung, ein Gehäuse für ein Leistungselektronik-Bauteil eines elektrifizierten Antriebsstrangs eines Elektromotor-, Hybridmotor- oder Brennstoffzellen-Fahrzeugs anzugeben, das im Betrieb das Leistungselektronik-Bauteil effektiv kühlt, das kostengünstig herstellbar ist und das zudem leicht ist.

Des Weiteren soll ein Herstellungsverfahren für ein solches Gehäuse angegeben werden, das einfach und kostengünstig durchführbar ist und mit dem ein effektiv kühlendes und leichtes Gehäuse für ein Leistungselektronik-Bauteil erhältlich ist.

Diese Aufgabe wird durch ein Leistungselektronik-Bauteil mit einem Spritzgussgehäuse gemäß Anspruch 1 und durch ein Verfahren zum Herstellen eines Spritzgussgehäuses für ein Leistungselektronik-Bauteil nach Anspruch 12 gelöst.

Alle Vorteile und Ausführungsformen, die nachstehend mit Bezug auf das Spritzgussgehäuse angegeben werden, treffen in gleicher Weise für das erfindungsgemäße Leistungselektronik-Bauteil eines elektrifizierten Antriebsstrangs eines Elektromotor-, Hybridmotor- oder Brennstoffzellen-Fahrzeugs mit einem solchen Spritzgussgehäuse zu.

Gemäß einem Grundgedanken der vorliegenden Erfindung transportiert ein erfindungsgemäßes Spritzgussgehäuse die in dem Leistungselektronik-Bauteil entstehende Wärme effektiv nach außen ab, weil es das Leistungselektronik-Bauteil im Wesentlichen vollständig umschließt, weil dessen gut wärmeleitfähiges Kunststoffmaterial für eine effektive Wärmeableitung/einen effektiven Wärmeabtransport nach außen sorgt und weil zudem das Kühlmittel durch das in den Gehäusekörper eingegossene Kühlungsrohr aus einer Aluminium-Legierung, oder einer Kupfer-Legierung strömt und zudem für eine effektive Wärmeableitung sorgt.

Bei der Aluminium-Legierung handelt es sich um eine Aluminium-Legierung der 3000er Serie, der 5000er Serie, der 6000er Serie oder der 9000er Serie. Bei der Kupfer-Legierung handelt es sich um CuNi10Fe1 Mn oder CuNi30Mn1 Fe nach den Normen EN 12449, EN 12735-1 oder EN 13600.

Gemäß einem weiteren Grundgedanken der Erfindung ist das erfindungsgemäße Spritzgussgehäuse besonders leicht bzw. hat eine geringe Masse/ein geringes Gewicht, weil der Gehäusekörper nicht aus verhältnismäßig schwerem Aluminiummaterial, sondern aus leichtem Kunststoffmaterial gefertigt ist.

Dieser Gewichts- und Massenvorteil ist besonders groß, wenn das in den Gehäusekörper eingegossene Kühlungsrohr, anstelle aus Stahl, aus einem Aluminiummaterial oder einer Aluminium-Legierung gefertigt ist, das eine geringere Dichte als Stahl aufweist.

Wenn das in den Gehäusekörper eingegossene Kühlungsrohr, anstelle aus Stahl, aus einer Kupfer-Legierung gefertigt ist, die von Haus aus eine höhere Dichte aufweist, resultiert der Gewichts- und Massenvorteil aus dem leichtem Kunststoffmaterial des Spritzgussgehäuses.

Ein Spritzgussgehäuse aus leichtem Kunststoffmaterial mit einem in den Gehäusekörper eingegossenen Kühlungsrohr aus einer Kupfer-Legierung stellt einen besonders günstigen Kompromiss zwischen guter Wärmeableitung und Wärmeleitfähigkeit einerseits sowie geringem Gewicht und geringer Masse andererseits dar.

Erfindungsgemäß werden somit Gewichts- und Massenvorteile gegenüber herkömmlichen Aluminiumdruckgussgehäusen erreicht.

Das Gesamtgewicht des Fahrzeugs wird somit reduziert. Zudem eignet sich ein erfindungsgemäßes Spritzgussgehäuse auch für Einsatzfelder, bei denen herkömmliche Aluminiumdruckgussgehäuse aufgrund von deren zu hohem Gewicht nicht eingesetzt werden konnten.

Das erfindungsgemäße Spritzgussgehäuse ist im Wege des Kunststoffspritzgusses gefertigt, bei dem gleich beim Spritzgießen wenigstens eines Teils des Gehäusekörpers ein Kühlungsrohr aus einer Aluminium-Legierung, oder einer Kupfer-Legierung mit eingegossen wird, was eine besonders kostengünstige Herstellung ermöglicht.

Die zwei oder mehreren Teile des Gehäusekörpers bilden einen inneren Aufnahmeraum für das Leistungselektronik-Bauteil aus, dessen Innenabmessungen im Wesentlichen den Außenabmessungen des Leistungselektronik-Bauteils entsprechen, so dass dieses passgenau in den Aufnahmeraum eingesetzt und in diesem positionssicher aufgenommen wird.

Die zwei oder mehreren Teile des Gehäusekörpers werden nach Einbringung des Leistungselektronik-Bauteils in den Aufnahmeraum miteinander verbunden, insbesondere miteinander verschraubt und verschließen dieses im Wesentlichen vollständig, mit Ausnahme der Anschlusskontakte für das Leistungselektronik-Bauteil, die auf geeignete Weise aus dem Gehäusekörper heraus und zu den vor- und nachgelagerten elektrischen Komponenten geführt werden.

Das Leistungselektronik-Bauteil ist im eingebauten Zustand im elektrifizierten Antriebsstrang des Elektromotor-, Hybridmotor- oder Brennstoffzellen-Fahrzeugs mit seinem Kühlungsrohr aus einer Aluminium-Legierung oder einer Kupfer-Legierung so an einen Kühlkreislauf angeschlossen, dass im Betrieb ein Kühlmittel durch dieses Kühlungsrohr strömt.

Bei dem Leistungselektronik-Bauteil handelt es sich um ein Leistungselektronik-Bauteil eines elektrifizierten Antriebsstrangs eines Elektromotor-, Hybridmotoroder Brennstoffzellen-Fahrzeugs handeln, nämlich um einen DC/DC-Wandler eines Elektromotor-, Hybridmotor- oder Brennstoffzellen-Fahrzeugs, bei dem eine Umhausung zum Schutz vor äußeren Einflüssen oder Einwirkungen gewünscht ist, und bei dem es auf einen effektiven Abtransport/eine effektive Ableitung der im Betrieb des Leistungselektronik-Bauteils entstehenden Wärme ankommt.

Durch den erfindungsgemäßen effektiven Wärmeabtransport kann das Leistungselektronik-Bauteil auf dem vorgesehenen Temperaturniveau gehalten und somit sein ordnungsgemäßer Betrieb gewährleistet werden. Die Wärme, die bei Leistungselektronik-Bauteilen entsteht, resultiert aus den verhältnismäßig hohen Strömen, die bei deren Betrieb fließen. Dies ist bei einem DC/DC-Wandler eines Elektromotor-, Hybridmotor- oder Brennstoffzellen-Fahrzeugs in besonderem Maße gegeben.

Das erfindungsgemäße Spritzgussgehäuse für ein Leistungselektronik-Bauteil mit in dem Gehäusekörper eingegossenem Kühlungsrohr aus einer Aluminium-Legierung oder einer Kupfer-Legierung, stellt ein komplettes lieferfertiges Bauteil dar.

Das erfindungsgemäße Herstellungsverfahren gemäß Anspruch 12 ist einfach und kostengünstig durchführbar.

Durch die Spritzgussform für einen Teil des Kunststoffgehäuses, insbesondere für das Basisteil, wird die Kontur desselben vorgegeben. Dadurch, dass das leere Kühlungsrohr aus einer Aluminium-Legierung oder einer Kupfer-Legierung direkt in der Spritzgussform positioniert wird, wird dieses beim Einspritz-Schritt wenigstens bereichsweise durch das eingespritzte, gut wärmeleitfähige Kunststoffmaterial umhüllt und dieses in das Kunststoffgehäuseteil, insbesondere in das Basisteil eingespritzt.

Trotz der signifikanten Gewichtsersparnis gegenüber einem AluminiumDruckgussgehäuse können das Volumen und/oder die Außenabmessungen in etwa gleich groß gehalten werden, wie bei einem Aluminium-Druckgussgehäuse. Es ergibt sich also kein Zuwachs an Volumen und auch keine Vergrößerung der Außenabmessungen.

Die Außenabmessungen eines erfindungsgemäßen Spritzgussgehäuses können variieren und auf das jeweilige zu umschließende Leistungselektronik-Bauteil abgestimmt werden.

Gemäß einem weiteren Grundgedanken der vorliegenden Erfindung kann bei einem erfindungsgemäßen Spritzgussgehäuse als Kühlungsrohr ein leichtes, gleichzeitig, aber für den erfindungsgemäßen Kühlbetrieb völlig ausreichendes Kühlungsrohr aus einer Aluminium-Legierung zum Einsatz kommen, was bei bisherigen Gehäusen aus Aluminiumdruckguss nicht oder nur schwierig möglich war. Bei bisherigen Aluminiumdruckgussgehäusen musste zumeist ein Stahlrohr hergenommen werden, weil ein Aluminiumrohr dem Druck, der bei üblichen Aluminiumdruckgussverfahren herrscht, nicht standgehalten und sich verformt hätte.

Um eine solche Verformung zu vermeiden und um bei einem Aluminiumdruckgussverfahren dennoch ein Rohr aus einer Aluminium-Legierung, hernehmen zu können, hätte dies mit einem Füllstoff, insbesondere mit Sand gefüllt werden müssen.

Bei den niedrigen Drucklagen beim Kunststoffspritzguss ist eine Verformung des erfindungsgemäßen Kühlungsrohrs aus einer Aluminium-Legierung und auch eine Verformung des erfindungsgemäßen Kühlungsrohrs aus einer Kupfer-Legierung nicht zu befürchten, und auf eine Füllung desselben mit einem Füllstoff wie Sand kann erfindungsgemäß verzichtet werden.

Besonders gut geeignet als gut wärmeleitfähige Kunststoffmaterialien des Gehäusekörpers sind Kunststoffmaterialien mit einer oder mehreren der folgenden Eigenschaften: Zugfestigkeit im Bereich von 20 MPa bis 250 MPa, Wärmeleitfähigkeit im Bereich 0,8 W/mK bis 50 W/mK, insbesondere 0,8 W/mK bis 30 W/mK, Dichte von 1,0 g/cm³ bis 5,0 g/cm³.

Das gut wärmeleitfähige Kunststoffmaterial des Gehäusekörpers ist aus Polyamid(e) (PA), oder Polycarbonat(e) (PC).

Gemäß einer weiteren Ausführungsform liegt die Wandstärke des Gehäusekörpers im Bereich 1 bis 4 mm. Durch eine solche verhältnismäßig geringe Wandstärke wird einerseits ein geringer Materialeinsatz und daraus resultierend geringe Herstellungskosten und andererseits eine verhältnismäßig kleine Außenkontur und somit ein geringes Volumen insgesamt erreicht.

Auch das Basisteil (mit Ausnahme des eingespritzten Kühlungsrohrs aus einer Aluminium-Legierung, oder einer Kupfer-Legierung) und die Deckelplatte des Spritzgussgehäuses können ebenfalls eine solche Wandstärke aufweisen, und können somit ebenfalls als Wand bezeichnet werden.

Gemäß der Erfindung ist das gut wärmeleitfähige Kunststoffmaterial mit einem metallischen, keramischen oder mineralischen Füllstoff gefüllt.

Durch den metallischen, keramischen oder mineralischen Füllstoff, mit dem das Kunststoffmaterial gefüllt ist, wird die Wärmeableitung und Wärmeleitfähigkeit weiter verbessert, bei nur geringfügiger Gewichts- und Massenzunahme. Das Gesamtgewicht und die Gesamtmasse ist trotz Füllstoff deutlich geringer als bei einem herkömmlichen Aluminiumdruckgussgehäuse.

Der metallische, keramische oder mineralische Füllstoff wird dabei insbesondere zusammen mit dem gut wärmeleitfähigen Kunststoffmaterial eingespritzt.

Gemäß einer weiteren Ausführungsform ist der metallische, keramische oder mineralische Füllstoff als Vielzahl von in dem gut wärmeleitfähigen Kunststoffmaterial verteilten Partikeln ausgebildet, die insbesondere einen Durchmesser / eine Länge von 1 µm bis 0,3 mm haben.

Gemäß einer weiteren Ausführungsform macht der metallische, keramische oder mineralische Füllstoff einen prozentualen Anteil von 5 bis 80%, insbesondere 5 bis 40%, bezogen auf das gut wärmeleitfähige Kunststoffmaterial, aus.

Gemäß der Erfindung ist der Füllstoff des gut wärmeleitfähigen Kunststoffmaterials ein metallischer Füllstoff, aus Kupfer oder Aluminium; oder ein keramischer oder mineralischer Füllstoff, aus Bornitrid, Graphit oder Glasfasern.

Gemäß einer weiteren Ausführungsform weist der Gehäusekörper ein Basisteil und ein Deckelteil auf, die miteinander verschraubt sind und das Leistungselektronik-Bauteil/Thermomanagement-Element passgenau dazwischen aufnehmen.

Gemäß einer weiteren Ausführungsform ist das Kühlungsrohr in das Basisteil des Gehäusekörpers eingespritzt. Das Kühlungsrohr kann dabei vollständig in das Basisteil eingespritzt sein bzw. das gut wärmeleitfähige Kunststoffmaterial des Basisteils kann die Mantelfläche des Kühlungsrohrs vollständig umgeben, ggf. mit Ausnahme der Rohranschlussenden. Dadurch wird die Kontaktfläche von dem gut wärmeleitfähigen Kunststoffmaterial zu dem Kühlungsrohr aus einer Aluminium-Legierung, oder einer Kupfer-Legierung maximiert und eine besonders gute Wärmeableitung erreicht.

Das erste und das zweite Rohrende können dabei insbesondere in Richtung einer langen Seite des Gehäusekörpers herausstehen.

Gemäß einer weiteren Ausführungsform hat die Grundfläche des Gehäusekörpers im Wesentlichen eine rechteckige Gestalt, mit zwei Kurzseiten und zwei Langseiten und insbesondere mit einem mittleren Vorsprung an einer Langseite.

Gemäß einer weiteren Ausführungsform verfügt das Spritzgussgehäuse-Basisteil über eine Basisplatte und über sich an den Kurzseiten und den Langseiten bzw. dem mittleren Vorsprung nach oben erstreckenden Wandbereichen. An den Ecken kann das Spritzgussgehäuse-Basisteil jeweils obere Ecklaschen mit Verschraubungslöchern mit Gewinde aufweisen. Auf diese sowie auf die oberen Ränder der Wandbereiche wird das obere Spritzgussgehäuse-Deckelteil mit seinen korrespondierenden Rand- und Eckbereichen aufgesetzt. Das Spritzgussgehäuse-Basisteil und das Spritzgussgehäuse-Deckelteil werden miteinander verschraubt, unter Einfassung eines Leistungselektronik-Bauteils eines elektrifizierten Antriebsstrangs eines Elektromotor-, Hybridmotor- oder Brennstoffzellen-Fahrzeugs, nämlich eines DC/DC-Wandlers, aus dem Wärme abgeführt werden soll, in den Aufnahmeraum, der von der Deckelplatte des oberen Spritzgussgehäuse-Deckelteils und von den Wandbereichen und von der Basisplatte des unteren Spritzgussgehäuse-Basisteils gebildet wird.

Gemäß einer weiteren Ausführungsform erstreckt sich das Kühlungsrohr über einen Großteil der Länge und der Breite des Basisteils.

Gemäß einer weiteren Ausführungsform weist das Kühlungsrohr ein erstes Rohrende und ein zweites Rohrende auf. Das erste Rohrende und das zweite Rohrende können jeweils an derselben ersten Längsseite des Basisteils angeordnet sein.

Das Kühlungsrohr kann jeweils an das erste und das zweite Rohrende ansetzende gerade Rohranfangsbereiche, die sich in Richtung zu der gegenüberliegenden Längsseite des Basisteils erstrecken, aufeinander zu gerichtete Rohr-Krümmungsbereiche und einen die beiden Rohr-Krümmungsbereiche verbindenden Rohr-Mittelbereich aufweisen. Der Rohr-Mittelbereich kann dabei nahe der ersten Längsseite des Basisteils gelegen sein.

Ein solcher Kühlungsrohrverlauf ist mit einer verhältnismäßig geringen Anzahl an in das Kühlungsrohr einzubringenden Rohrbiegungen noch kostensparend herstellbar, ist aber gleichermaßen kompakt und bietet aufgrund der hohen Kontaktfläche zu dem gut wärmeleitfähigen Kunststoffmaterial des Gehäusekörpers bzw. des Basisteils des Gehäusekörpers eine effektive Wärmeableitung zu dem Kühlungsrohr, das im Betrieb das Kühlungsrohr durchströmt.

Die Anzahl der Rohrbiegungen des Kühlungsrohrs aus einer Aluminium-Legierung, oder einer Kupfer-Legierung können variieren und insbesondere größer oder kleiner sein, als in den zwei letzten Absätzen angegeben.

Gemäß einer weiteren Ausführungsform ist eine Vielzahl von Wärmeabführrippen integral in dem Basisteil ausgebildet, insbesondere angrenzend an die Kühlungsrohr-Umhüllungsbereiche des Basisteils.

Gemäß einer weiteren Ausführungsform nehmen die Wärmeabführrippen einen Bereich von 20 bis 50 % der Oberfläche des Basisteils ein.

Die Wärmeabführrippen können an den geraden Rohranfangsbereichen, an den Rohr-Krümmungsbereichen und an dem Rohr-Mittelbereich angeordnet sein, insbesondere jeweils zu beiden Seiten des Kühlungsrohrs.

Durch solche Wärmeabführrippen wird die Wärmeableitung an die Umgebung deutlich vergrößert.

Gemäß einer weiteren Ausführungsform liegt die Länge des Gehäusekörpers im Bereich zwischen 50 und 1000 mm, insbesondere 50 und 400 mm, die Breite des Gehäusekörpers im Bereich zwischen 50 und 1000 mm, insbesondere 50 und 400 mm und die Höhe des Gehäusekörpers im Bereich zwischen 20 und 500 mm, insbesondere 20 und 200 mm.

Durch solche Abmessungen des Gehäusekörpers können übliche Leistungselektronik-Bauteile eines elektrifizierten Antriebsstrangs eines Elektromotor-, Hybridmotor- oder Brennstoffzellen-Fahrzeugs und übliche Thermomanagement-Elemente eines Elektromotor-, Hybridmotor- oder Brennstoffzellen-Fahrzeugs passgenau umschlossen werden.

Gemäß einer weiteren Ausführungsform weist das Spritzgussgehäuse einschließlich des in das Basisteil integrierten Kühlungsrohrs eine Masse von 100 g bis 20.000 g, insbesondere 100 g bis 1.000 g bzw. ein Gewicht von 0,981 N bis 196,2 N, insbesondere 0,981 N bis 9,81 N auf, bei Abmessungen im Bereich von 50 und 1000 mm bzw. 50 mm bis 400 mm Länge, von 50 mm bis 1000 mm bzw. 50 mm bis 400 mm Breite und von 20 mm bis 500 mm bzw. 20 mm bis 200 mm Höhe.

Die Masse/das Gewicht des erfindungsgemäßen Spritzgussgehäuses entspricht weniger als der Hälfte der Masse/des Gewichts eines entsprechenden Aluminiumdruckgussgehäuses mit vergleichbaren Abmessungen.

Gemäß einer Ausführungsform des erfindungsgemäßen Leistungselektronik-Bauteils ist dieses als DC/DC-Wandler ausgebildet, das im Betrieb die Spannung von etwa 1000 V auf 12V oder von etwa 48 V auf 12 V heruntertransformiert.

Gemäß einer weiteren Ausführungsform des erfindungsgemäßen Leistungselektronik-Bauteils fließt in dem DC-DC-Wandler, ein Strom von 10 A bis 500 A und erfolgt demzufolge eine Erhitzung auf 50 °C bis 120 °C, insbesondere auf 50 °C bis 80 °C. Die Wärme wird durch das Spritzgussgehäuse aus gut wärmeleitfähigem Kunststoff mit integriertem Kühlungsrohr abgeführt.

Gemäß einer ersten Ausführungsform des Verfahrens wird das Deckelteil des Kunststoffgehäuses durch die folgenden Schritte hergestellt:
Bereitstellen wenigstens einer Spritzgussform für das Deckelteil;
Einspritzen eines gut wärmeleitfähigen Kunststoffmaterials, das mit einem metallischen, keramischen oder mineralischen Füllstoff gefüllt ist, in die Spritzgussform, wobei das Einspritzen des gut wärmeleitfähigen Kunststoffmaterials bei einer Temperatur von 200 °C bis 400 °C und/oder einem Druck von von 50 bar bis 2000 bar, insbesondere 50 bar bis 700 bar erfolgt; und
Aushärtenlassen des Kunststoffmaterials und Entnehmen des Deckelteils aus der Spritzgussform.

Die Einspritztemperatur ist deutlich geringer als die Temperatur, bei der üblicherweise ein Aluminiumdruckguss erfolgt. Ebenso ist der Einspritzdruck deutlich geringer als der Druck, bei dem üblicherweise ein Aluminiumdruckguss erfolgt. Somit ist das erfindungsgemäße Verfahren auch deswegen kostengünstiger durchführbar.

In vielen Fällen ist es ausreichend, wenn nur in ein Teil des Gehäusekörpers, insbesondere in das Basisteil ein Kühlungsrohr aus einer Aluminium-Legierung oder einer Kupfer-Legierung eingespritzt wird.

Gemäß einer weiteren Ausführungsform des Verfahrens werden das Basisteil und das Deckelteil des Spritzgussgehäuses unter Umschließen des als DC/DC-Wandler ausgebildeten Leistungselektronik-Bauteils miteinander verbunden, insbesondere verschraubt.

Die Erfindung ist nachfolgend anhand von Ausführungsbeispielen mit Bezug auf die beiliegenden Figuren näher erläutert.
Fig. 1 zeigt eine Draufsicht auf ein Spritzgussgehäuse-Basisteil gemäß einem Ausführungsbeispiel der Erfindung;
Fig. 2 zeigt eine Schnittdarstellung des Spritzgussgehäuse-Basisteils aus Fig. 1, geschnitten entlang einer horizontalen Schnittebene, die in etwa durch einen mittleren Abschnitt der Rohr-Anfangsbereiche, der Rohr-Krümmungsbereiche und des Rohr-Mittelbereichs des eingegossenen Kühlungsrohrs verläuft, gemäß dem Ausführungsbeispiel aus Fig. 1;
Fig. 3 zeigt eine Ansicht von unten auf das Spritzgussgehäuse-Basisteil aus den Fig. 1 und 2;
Fig. 4 zeigt eine Seitenansicht von links des Spritzgussgehäuse-Basisteils aus den Fig. 1, 2 und 3;
Fig. 5 zeigt eine Ansicht eines zu dem Spritzgussgehäuse-Basisteil aus den Fig. 1 bis 4 passenden Spritzgussgehäuse-Deckelteils aus Fig. 4 von unten; und
Fig. 6 zeigt eine Seitenansicht des Spritzgussgehäuse-Deckelteils aus der Fig. 5 von vorn.

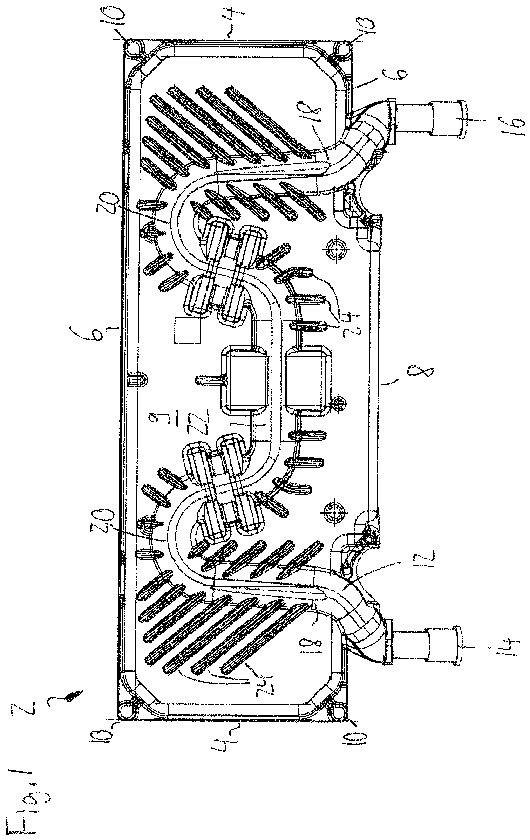

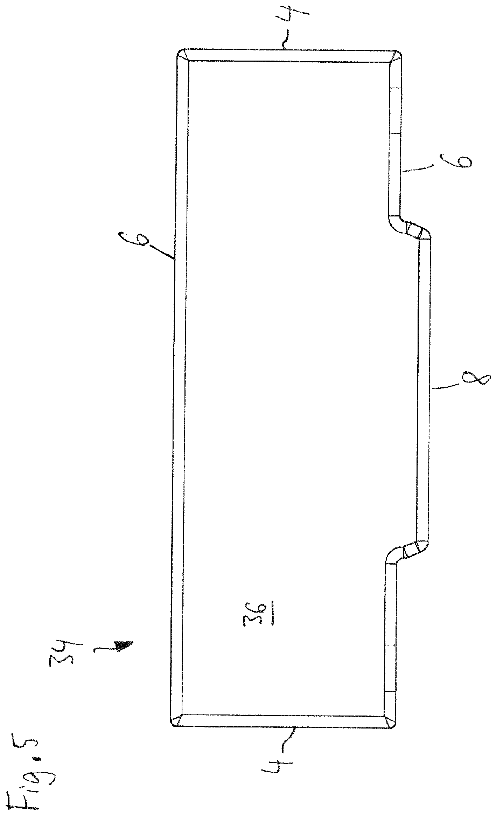

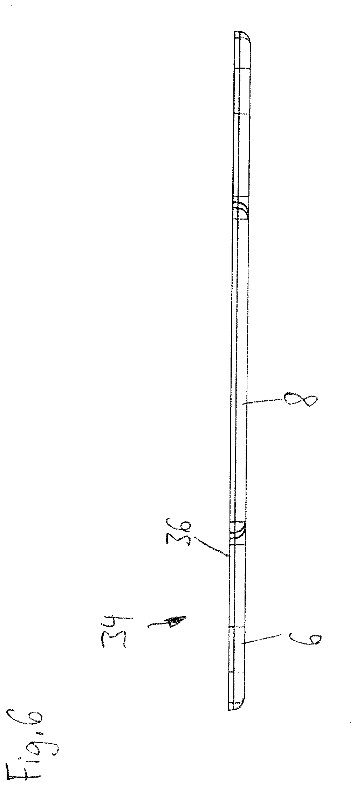

Das Spritzgussgehäuse-Basisteil 2 aus den Figuren 1 bis 4 und das Spritzgussgehäuse-Deckelteil 34 aus den Figuren 5 und 6 haben beide eine im Wesentlichen rechteckige Grundform mit linken und rechten Kurzseiten 4 und mit vorderen und hinteren Langseiten 6, wobei in der vorderen Langseite 6 ein mittlerer Vorsprung 8 nach vorn ausgebildet ist.

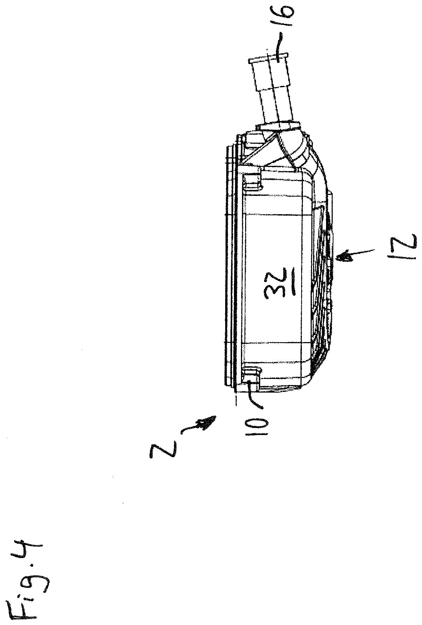

Das Spritzgussgehäuse-Basisteil 2 verfügt über eine Basisplatte 9 und über sich an den Kurzseiten 4 und den Langseiten 6 bzw. dem mittleren Vorsprung 8 nach oben, also in Fig. 1 in der Zeichnungsebene nach unten erstreckenden Wandbereiche 32, siehe Fig. 4.

An den Ecken hat das Spritzgussgehäuse-Basisteil 2 jeweils obere Ecklaschen mit Verschraubungslöchern mit Gewinde 10. Auf diese sowie auf die oberen Ränder der Wandbereiche 32 wird das Spritzgussgehäuse-Deckelteil 34 mit seinen korrespondierenden Rand- und Eckbereichen aufgesetzt.

Mittels Schrauben, die von oben durch entsprechende Löcher des Spritzgussgehäuse-Deckelteils 34 (nicht gezeigt) geführt werden und die in die Verschraubungslöcher mit Gewinde an den Ecklaschen 10 des Spritzgussgehäuse-Basisteils 2 einschraubt werden, wird das Spritzgussgehäuse-Basisteil 2 mit dem Spritzgussgehäuse-Deckelteil 34 verbunden, nach vorheriger Einbringung eines in dem Spritzgussgehäuse aufzunehmenden Leistungselektronik-Bauteils eines elektrifizierten Antriebsstrangs eines Elektromotor-, Hybridmotor- oder Brennstoffzellen-Fahrzeugs, nämlich eines DC/DC-Wandlers (nicht gezeigt), aus dem Wärme abgeführt werden soll.

Die inneren Abmessungen des von der Basisplatte 9 und den Wandbereichen 32 des unteren Spritzgussgehäuse-Basisteils 2 und von der Deckelplatte 36 des Spritzgussgehäuse-Deckelteils 34 gebildeten Aufnahmeraums entsprechen dabei den äußeren Abmessungen des Leistungselektronik-Bauteils, das somit positionssicher in dem Spritzgussgehäuse aufgenommen und in diesem positionssicher gehaltert ist.

Das Leistungselektronik-Bauteil verfügt des Weiteren über elektrische Anschlusskontakte, die auf geeignete Weise aus dem Spritzgussgehäuse herausgeführt und mit den vor- und nachgelagerten elektronischen Komponenten des Antriebsstrangs des Elektromotor-, Hybridmotor- oder Brennstoffzellen-Fahrzeugs bzw. mit den entsprechenden Komponenten des Elektromotor-, Hybridmotor- oder Brennstoffzellen-Fahrzeugs verbunden werden (nicht gezeigt).

In das Spritzgussgehäuse-Basisteil 2 ist ein Kühlungsrohr aus einer Aluminium-Legierung oder einer Kupfer-Legierung 12 eingegossen. Dieses wird im eingebauten Zustand des Spritzgussgehäuses mit Leistungselektronik-Bauteil im elektrifizierten Antriebsstrang eines Elektromotor-, Hybridmotor- oder Brennstoffzellen-Fahrzeugs mit seinen Rohrenden 14, 16 an einen Kühlkreislauf angeschlossen, so dass im Betrieb ein Kühlmittel durch das eingegossene Kühlungsrohr 12 strömt.

Das Kühlungsrohr aus einer Aluminium-Legierung oder einer Kupfer-Legierung hat ein erstes Rohrende 14 und ein zweites Rohrende 16, die beide an der vorderen Langseite 6, an einem linken und rechten Endbereich davon, nach vorne von dem Spritzgussgehäuse-Basisteil 2 wegstehen und nicht in das Kunststoffmaterial des Spritzgussgehäuse-Basisteils 2 eingegossen sind. Die beiden Rohrenden 14, 16 sind dabei insbesondere etwas oberhalb des Niveaus der Basisplatte 9 angeordnet und stehen nach vorne weg, siehe Figur 4.

Der Bereich des Kühlungsrohrs 12 zwischen den beiden Rohrenden 14 und 16 ist vollständig in das Kunststoffmaterial des Spritzgussgehäuse-Basisteils 2 eingegossen. Der zwischen den beiden Rohrenden 14 und 16 liegende eingegossene Bereich des Kühlungsrohrs aus einer Aluminium-Legierung oder einer Kupfer-Legierung 12 gliedert sich in Rohr-Anfangsbereiche 18, in Rohr-Krümmungsbereiche 20 und in einen Rohrmittelbereich 22. Das Kühlungsrohr 12 hat dabei einen symmetrischen Verlauf, bezogen auf die horizontale Mittelachse zwischen den beiden Kurzseiten 4 des Spritzgussgehäuse-Basisteils 2. In den Rohr-Anfangsbereichen 18 steigt das Kühlungsrohr aus einer Aluminium-Legierung oder einer Kupfer-Legierung 12, jeweils bezogen auf das jeweilige Rohrende 14, 16 an, und ist ein Stück weit nach innen gekrümmt, bis es das Niveau der Basisplatte 9 erreicht hat. Ab dieser Position erstreckt sich der jeweilige Rohr-Anfangsbereich 18 in Richtung zu der hinteren Längsseite 6 des Spritzgussgehäuse-Basisteils 2.

Danach gehen die beiden Rohr-Anfangsbereiche 16 in jeweilige Rohr-Krümmungsbereiche 20 über, in denen das Kühlungsrohr 12 eine Biegung nach innen und nach vorne beschreibt, über einen Winkelbereich von etwa 160 bis 170°, und sich das Kühlungsrohr 12 wieder in Richtung nach vorne zu der vorderen Langseite 6, und insbesondere zu dem mittleren Vorsprung 8 hin erstreckt. Die vorderen Enden der Rohr-Krümmungsbereiche 20 werden durch einen im Wesentlichen parallel zu den Längsseiten 6 verlaufenden Rohr-Mittelbereich 22 verbunden. Der Rohr-Mittelbereich 22 ist dabei nahe der vorderen Längsseite 6, insbesondere des mittleren Vorsprungs 6 der vorderen Längsseite 6 angeordnet.

Die hier beschriebene und in den Figuren 1 bis 4 gezeigte Ausführung des Kühlungsrohrs 12 mit Rohr-Anfangsbereichen 16, Rohr-Krümmungsbereichen 20 und Rohr-Mittelbereich 22 ist nur exemplarisch. Selbstverständlich kann das Kühlungsrohrs 12 aus einer Aluminium-Legierung oder einer Kupfer-Legierung auch anders ausgeführt werden.

Somit erstreckt sich der eingegossene Bereich des Kühlungsrohrs 12 über einen Großteil der Breite und Länge der Basisplatte 9 des Spritzgussgehäuse-Basisteils 2, und mit seinen Rohr-Anfangsbereichen 18 sogar ein Stück nach vorne und schräg nach unten (Fig. 4) über die Basisplatte 9 hinaus.

Des Weiteren sind eine Vielzahl von Wärmeabführrippen 24 integral in dem Basisteil 2 ausgebildet. Dabei verlaufen die Wärmeabführrippen 24 jeweils beidseitig angrenzend an die Rohr-Anfangsbereiche 18, an die Rohr-Krümmungsbereiche 20 und an den Rohr-Mittelbereich 22. Die Wärmeabführrippen 24, die an die RohrAnfangsbereiche 18 angrenzen, haben dabei insbesondere eine schräge annähernd diagonale Erstreckung und weisen in den jeweils zu der benachbarten Kurzseite 4 gelegenen Seite eine größere Länge auf als in der davon abgewandten Seite. In dem Rohr-Krümmungsbereich 20 und in dem Rohr-Mittelbereich 22 erstrecken sich die Wärmeabführrippen 24 im Wesentlichen radial nach außen. Insgesamt nehmen die Wärmeabführrippen 24 einen Bereich von 20 bis 50%, insbesondere von etwa 30% der Oberfläche des Basisteils 2 ein.

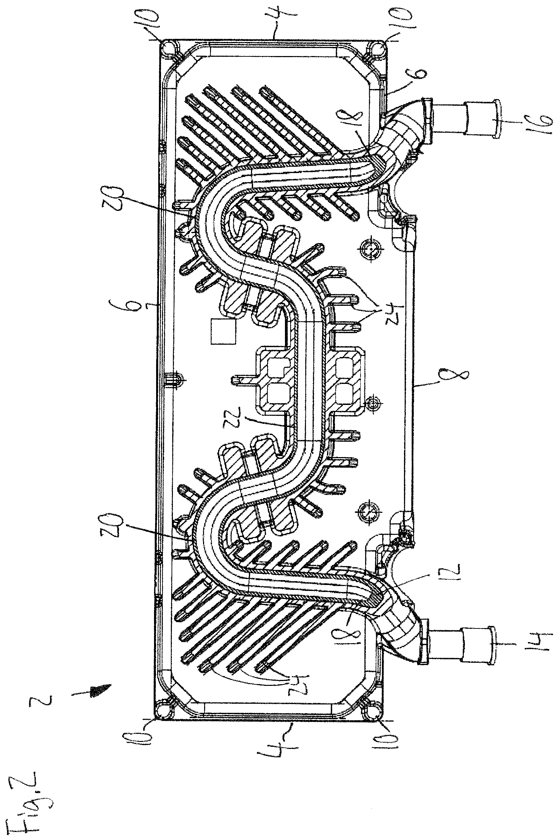

Die hier beschriebene und in den Figuren 1 und 2 gezeigte Ausführung der Wärmeabführrippen 24 ist nur exemplarisch. Selbstverständlich können die Wärmeabführrippen 24 auch anders ausgeführt oder sogar ganz weggelassen werden.

In Fig. 2 ist das Innere des Kühlungsrohrs aus einer Aluminium-Legierung oder einer Kupfer-Legierung 12 in den Rohr-Anfangsbereichen 18, in den Rohr-Krümmungsbereichen 20 und in dem Rohr-Mittelbereich 22 zu erkennen, durch das im Betrieb das Kühlmittel fließt. Des Weiteren ist zu erkennen, dass die Höhe der Wärmeabführrippen 24 jeweils von deren äußerem Ende bis zu dem an dem jeweiligen Rohrumhüllungsbereich angrenzenden Ende zunimmt.

Des Weiteren sind am Übergang zwischen den Rohr-Krümmungsbereichen 20 und dem Rohr-Mittelbereich 22 beidseitig jeweils zwei Verstärkungsstege vorgesehen. Zentral am Rohr-Mittelbereich 22 ist ein breiterer Verstärkungsabschnitt vorgesehen.

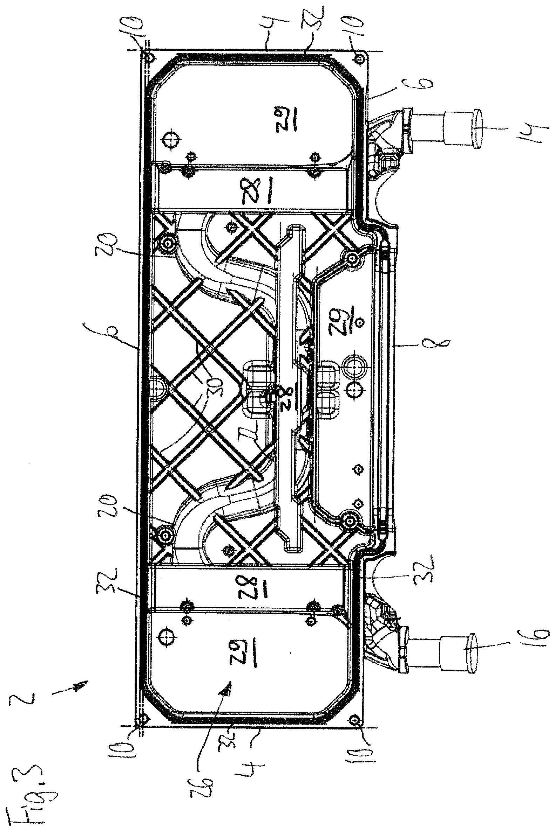

In Fig. 3 sind innere Auflageflächen 28 zu erkennen, auf denen das Leistungselektronik-Bauteil (nicht gezeigt) mit seiner Unterseite aufliegt, wenn das Leistungselektronik-Bauteil in den Aufnahmeraum 26 zwischen Spritzgussgehäuse-Basisteil 2 und Spritzgussgehäuse-Deckelteil 34 eingebracht und die beiden Teile miteinander verschraubt sind. Die inneren Auflageflächen 28 dienen dabei als Wärmeabführbereiche und können als solche bezeichnet werden.

Des Weiteren sind tieferliegende Flächen 29 benachbart den Kurzseiten 4 und an dem mittleren Vorsprung 8 zu erkennen, die im eingebrachten Zustand des Leistungselektronik-Bauteils in einem geringen Abstand zu der Unterseite des Leistungselektronik-Bauteils angeordnet sind.

In einem zentralen Bereich der Unterseite des Spritzgussgehäuse-Basisteils 2 sind gitterartig angeordnete rückseitige Verstärkungsrippen 30 zu erkennen, zwischen den inneren Auflageflächen 28 und dem eingegossenen Kühlungsrohr 12, insbesondere dessen Rohr-Krümmungsbereichen 20 und dessen Rohr-Mittelbereich 22.

Die hier beschriebene und in Figur 3 gezeigte Ausführung der Unterseite des Spritzgussgehäuse-Basisteils 2 ist nur exemplarisch. Selbstverständlich kann die Unterseite des Spritzgussgehäuse-Basisteils 2 auch anders ausgeführt werden.

Fig. 4 zeigt eine Seitenansicht von links des Spritzgussgehäuse-Basisteils 2. Man kann sich das Spritzgussgehäuse gut in zusammengeschraubtem Zustand vorstellen, in dem von oben ein Spritzgussgehäuse-Deckelteil 34, wie in den Figuren 5 und 6 gezeigt, auf das Spritzgussgehäuse-Basisteil 2 aufgesetzt wird und dieses z.B. mittels Schrauben (nicht gezeigt) daran befestigt wird, nach vorheriger Einbringung eines Leistungselektronik-Bauteils eines elektrifizierten Antriebsstrangs eines Elektromotor-, Hybridmotor- oder Brennstoffzellen-Fahrzeugs, nämlich eines DC/DC-Wandlers (nicht gezeigt), aus dem Wärme abgeführt werden soll (nicht gezeigt), in den Aufnahmeraum, der von der Basisplatte 9 und den Wandbereichen 32 des unteren Spritzgussgehäuse-Basisteils 2 und von der Deckelplatte 36 des oberen Spritzgussgehäuse-Deckelteils 34 gebildet ist.

Die Schrauben können dabei z.B. von oben durch entsprechende Löcher des Spritzgussgehäuse-Deckelteils 34 (nicht gezeigt) geführt werden und in die Verschraubungslöcher mit Gewinde an den Ecklaschen 10 des Spritzgussgehäuse-Basisteils 2 eingeschraubt werden.

Das in den Figuren 5 und 6 gezeigte Spritzgussgehäuse-Deckelteil 34 ist im Wesentlichen plattenartig ausgebildet. Dessen Grundform mit den beiden Kurzseiten 4, den beiden Langseiten 6 und dem mittleren vorderen Vorsprung 8 an der vorderen Langseite entspricht der Grundform des Spritzgussgehäuse-Basisteils 2.

Das Spritzgussgehäuse-Basisteil 2 und das Spritzgussgehäuse-Deckelteil 34 bilden zusammen einen Gehäusekörper. Sie sind aus gut wärmeleitfähigem Kunststoffmaterial, insbesondere aus einem thermisch konduktiven Compound durch ein Spritzgussverfahren hergestellt worden. Ein solches gut wärmeleitfähiges Kunststoffmaterial ist Polyamid(e) (PA) oder Polycarbonat(e) (PC). Die Zugfestigkeit des gut wärmeleitfähigen Kunststoffmaterials liegt dabei insbesondere im Bereich von 20 MPa bis 250 MPa. Die Wärmeleitfähigkeit des gut wärmeleitfähigen Kunststoffmaterials liegt dabei insbesondere im Bereich 0,8 W/mK bis 50 W/mK, insbesondere 0,8 W/mK bis 30 W/mK. Das gut wärmeleitfähige Kunststoffmaterial weist insbesondere eine Dichte von 1,0 g/cm³ bis 5,0 g/cm³ auf.

Das gut wärmeleitfähige Kunststoffmaterial ist mit einem metallischen, keramischen oder mineralischen Füllstoff gefüllt, der insbesondere mit eingespritzt wird.

Der metallische, keramische oder mineralische Füllstoff kann dabei als Vielzahl von in dem gut wärmeleitfähigen Kunststoffmaterial verteilten Partikeln ausgebildet sein, die insbesondere einen Durchmesser von 1 µm bis 0,3 mm haben. Der metallische, keramische oder mineralische Füllstoff kann einen prozentualen Anteil von 5 bis 80%, insbesondere 5 bis 40%, bezogen auf das gut wärmeleitfähige Kunststoffmaterial, ausmachen.

Der Füllstoff des gut wärmeleitfähigen Kunststoffmaterials ist ein metallischer Füllstoff aus Kupfer oder Aluminium,oder ein keramischer oder mineralischer Füllstoff, aus Bornitrid, Graphit oder Glasfasern.

Die Wandstärke der Wandbereiche 32 liegt im Bereich 1 bis 4 mm.

Die Länge des Gehäusekörpers liegt im Bereich zwischen 50 und 1000 mm, insbesondere 50 und 400 mm, die Breite des Gehäusekörpers liegt im Bereich zwischen 50 und 1000 mm, insbesondere 50 und 400 mm und die Höhe des Gehäusekörpers liegt im Bereich zwischen 20 und 500 mm, insbesondere 20 und 200 mm. Das Spritzgussgehäuse einschließlich des in das Basisteil 2 integrierten Kühlungsrohrs aus einer Aluminium-Legierung oder einer Kupfer-Legierung 12 hat eine Masse von 100 g bis 20.000 g, insbesondere 100 g bis 1.000 g bzw. ein Gewicht von 0,981 N bis 196,2 N, insbesondere 0,981 N bis 9,81 N, bei den o,g, Abmessungen.

Zu den Vorteilen und weiteren Ausbildungen des Spritzgussgehäuses und des Leistungselektronik-Bauteils sowie zum Herstellungsverfahren wird auf den allgemeinen Beschreibungsteil verwiesen, um Wiederholungen zu vermeiden. Die Erfindung ist im beigefügten Anspruchssatz definiert.

### Bezugszeichenliste

- 2: Spritzgussgehäuse-Basisteil
- 4: Kurzseiten
- 6: Langseiten
- 8: mittlerer Vorsprung
- 9: Basisplatte
- 10: Ecklaschen mit Verschraubungslöchern mit Gewinde
- 12: eingegossenes Kühlungsrohr
- 14: erstes Rohrende
- 16: zweites Rohrende
- 18: Rohranfangsbereiche
- 20: Rohr-Krümmungsbereiche
- 22: Rohr-Mittelbereich
- 24: Wärmeabführrippen
- 26: Aufnahmeraum
- 28: innere Auflageflächen
- 29: tieferliegende Flächen
- 30: rückseitige Verstärkungsrippen
- 32: Wandbereiche
- 34: Spritzgussgehäuse-Deckelteil
- 36: Deckelplatte

## Patentansprüche

1. Leistungselektronik-Bauteil eines elektrifizierten Antriebsstrangs eines Elektromotor-, Hybridmotor- oder Brennstoffzellen-Fahrzeugs, das als DC/DC-Wandler, eines Elektromotor-, Hybridmotor- oder Brennstoffzellen-Fahrzeugs ausgebildet ist, aufweisend:
ein Spritzgussgehäuse, aufweisend
einen Gehäusekörper aus zwei oder mehreren Teilen (2, 34), der so ausgebildet ist, dass er das Leistungselektronik-Bauteil im Wesentlichen vollständig umschließt; und
ein wenigstens teilweise in den Gehäusekörper (2, 34) eingegossenes Kühlungsrohr (12), das dazu bestimmt ist, dass im Betrieb ein Kühlmittel durch dieses Kühlungsrohr (12) strömt;
wobei der Gehäusekörper (12) aus einem gut wärmeleitfähigen Kunststoffmaterial ist;
wobei der Gehäusekörper (2, 34) aus gut wärmeleitfähigem Kunststoffmaterial das Leistungselektronik-Bauteil im Wesentlichen vollständig umschließt, und
wobei das wenigstens teilweise in den Gehäusekörper (2, 34) eingegossene Kühlungsrohr (12) so an einen Kühlkreislauf angeschlossen bzw. anschließbar ist, dass im Betrieb ein Kühlmittel durch dieses Kühlungsrohr (12) strömt,
**dadurch gekennzeichnet, dass**.
der Gehäusekörper (12) aus einem gut wärmeleitfähigen Kunststoffmaterial, aus Polyamid(e) (PA) oder aus Polycarbonat(e) (PC) ausgebildet ist, das mit einem metallischen Füllstoff, nämlich Kupfer oder Aluminium, oder mit einem keramischen oder mineralischen Füllstoff, nämlich Bornitrid, Graphit oder Glasfasern gefüllt ist; und
dass das wenigstens teilweise in den Gehäusekörper (2, 34) eingegossene Kühlungsrohr (12) aus einer Aluminium-Legierung der 3000er Serie, der 5000er Serie, der 6000er Serie oder der 9000er Serie, oder aus einer Kupfer-Legierung aus CuNi10Fe1Mn oder CuNi30Mn1Fe ist.

2. Leistungselektronik-Bauteil nach Anspruch 1,
wobei die Zugfestigkeit des gut wärmeleitfähigen Kunststoffmaterials des Gehäusekörpers (2, 34) im Bereich von 20 MPa bis 250 MPa liegt; und/oder
wobei die Wärmeleitfähigkeit des gut wärmeleitfähigen Kunststoffmaterials des Gehäusekörpers (2, 34) im Bereich 0,8 W/mK bis 50 W/mK, insbesondere 0,8 W/mK bis 30 W/mK liegt; und/oder
wobei das gut wärmeleitfähige Kunststoffmaterial des Gehäusekörpers (2, 34) eine Dichte von 1,0 g/cm³ bis 5,0 g/cm³ aufweist.

3. Leistungselektronik-Bauteil nach Anspruch 1 oder 2,
wobei die Wandstärke des Gehäusekörpers (2, 34) im Bereich 1 bis 4 mm liegt.

4. Leistungselektronik-Bauteil nach einem der vorhergehenden Ansprüche,
wobei der metallische, keramische oder mineralische Füllstoff insbesondere als Vielzahl von in dem gut wärmeleitfähigen Kunststoffmaterial verteilten Partikeln ausgebildet ist, die insbesondere einen Durchmesser /eine Länge von 1 µm bis 0,3 mm haben; und/oder
wobei der metallische, keramische oder mineralische Füllstoff insbesondere einen prozentualen Anteil von 5 bis 80%, insbesondere 5 bis 40%, bezogen auf das gut wärmeleitfähige Kunststoffmaterial, ausmacht.

5. Leistungselektronik-Bauteil nach einem der vorhergehenden Ansprüche,
wobei der Gehäusekörper (2, 34) ein Basisteil (2) und ein Deckelteil (34) aufweist, die miteinander verschraubt sind und das Leistungselektronik-Bauteil passgenau dazwischen aufnehmen.

6. Leistungselektronik-Bauteil nach Anspruch 5,
wobei das Kühlungsrohr (12) in das Basisteil (2) des Gehäusekörpers (2, 34) eingespritzt ist; und/oder
wobei das Kühlungsrohr (12) vollständig in das Basisteil (2) eingespritzt ist bzw. wobei das gut wärmeleitfähige Kunststoffmaterial des Basisteils (2) die Mantelfläche des Kühlungsrohrs (12) vollständig umgibt.

7. Leistungselektronik-Bauteil nach einem der vorhergehenden Ansprüche,
wobei die Grundfläche des Gehäusekörpers (2, 34) im Wesentlichen eine rechteckige Gestalt hat, mit zwei Kurzseiten (4) und zwei Langseiten (6) und insbesondere mit einem mittleren Vorsprung (8) an einer Langseite (6); und/oder
wobei sich das Kühlungsrohr (12) über einen Großteil der Länge und der Breite des Basisteils (2) erstreckt.

8. Leistungselektronik-Bauteil nach einem der vorhergehenden Ansprüche,
wobei das Kühlungsrohr (12) ein erstes Rohrende (14) und ein zweites Rohrende (16) aufweist; und/oder
wobei das erste Rohrende (14) und das zweite Rohrende (16) jeweils an derselben ersten Längsseite (6) des Basisteils (2) angeordnet sind; und/oder
wobei das Kühlungsrohr (12) jeweils an das erste Rohrende (14) und das zweite Rohrende (16) ansetzende gerade Rohranfangsbereiche (18), die sich in Richtung zu der gegenüberliegenden Längsseite (6) des Basisteils (2) erstrecken, aufeinander zu gerichtete Rohr-Krümmungsbereiche (20) und einen die beiden Rohr-Krümmungsbereiche (20) verbindenden Rohr-Mittelbereich (22) aufweisen; und/oder
wobei der Rohr-Mittelbereich (22) nahe der ersten Längsseite (6) des Basisteils (2) gelegen ist.

9. Leistungselektronik-Bauteil nach einem der vorhergehenden Ansprüche,
wobei eine Vielzahl von Wärmeabführrippen (24) integral in dem Basisteil (2) ausgebildet sind, insbesondere angrenzend an die Kühlungsrohr-Umhüllungsbereiche des Basisteils (2); und/oder
wobei die Wärmeabführrippen (24) einen Bereich von 20 bis 50 % der Oberfläche des Basisteils (2) einnehmen; und/oder
wobei Wärmeabführrippen (24) an den geraden Rohranfangsbereichen (18), an den Rohr-Krümmungsbereichen (20) und an dem Rohr-Mittelbereich (22) angeordnet sind, insbesondere jeweils zu beiden Seiten des Kühlungsrohrs (12).

10. Leistungselektronik-Bauteil nach einem der vorhergehenden Ansprüche,
wobei die Länge des Gehäusekörpers (2, 34) im Bereich zwischen 50 und 1000 mm, insbesondere 50 und 400 mm, die Breite des Gehäusekörpers (2, 34) im Bereich zwischen 50 und 1000 mm, insbesondere 50 und 400 mm und die Höhe des Gehäusekörpers (2, 34) im Bereich zwischen 20 und 500 mm, insbesondere 20 und 200 mm liegt; und/oder
wobei das Spritzgussgehäuse einschließlich des in das Basisteil (2) integrierten Kühlungsrohrs (12) eine Masse von 100 g bis 20.000 g, insbesondere 100 g bis 1.000 g bzw. ein Gewicht von 0,981 N bis 196,2 N, insbesondere 0,981 N bis 9,81 N aufweist, bei Abmessungen im Bereich von 50 und 1000 mm bzw. 50 mm bis 400 mm Länge, 50 und 1000 mm bzw. 50 mm bis 400 mm Breite und 20 und 500 mm bzw. 20 mm bis 200 mm Höhe.

11. Leistungselektronik-Bauteil nach einem der vorhergehenden Ansprüche,
wobei das als DC/DC-Wandler ausgebildete Leistungselektronik-Bauteil im Betrieb die Spannung von etwa 1000 V auf 12 V oder von 48 auf 12 V heruntertransformiert; und/oder
wobei in dem DC-/DC-Wandler, ein Strom von 10 A bis 500 A fließt und demzufolge eine Erhitzung auf 50 °C bis 120 °C, insbesondere auf 50 °C bis 80 °C erfolgt und die Wärme durch das Spritzgussgehäuse aus gut wärmeleitfähigem Kunststoff mit integriertem Kühlungsrohr (12) abgeführt wird.

12. Verfahren zum Herstellen eines Spritzgussgehäuses aus Kunststoff für ein Leistungselektronik-Bauteil eines elektrifizierten Antriebstrangs eines Elektromotor-, Hybridmotor- oder Brennstoffzellen-Fahrzeugs, das als DC/DC-Wandler ausgebildet ist, mit integriertem Kühlungsrohr (12), aufweisend die folgenden Schritte:
Bereitstellen wenigstens einer Spritzgussform für einen Teil des Kunststoffgehäuses (2, 34), insbesondere für das Basisteil (2);
Positionieren eines leeren Kühlungsrohrs aus einer Aluminium-Legierung der 3000er Serie, der 5000er Serie, der 6000er Serie oder der 9000er Serie, oder einer Kupfer-Legierung aus CuNi10Fe1Mn oder CuNi30Mn1Fe (12) in der Spritzgussform;
Einspritzen eines gut wärmeleitfähigen Kunststoffmaterials, nämlich Polyamid(e) (PA) oder Polycarbonat(e) (PC), das mit einem metallischen Füllstoff, nämlich Kupfer oder Aluminium, oder mit einem keramischen oder mineralischen Füllstoff, nämlich Bornitrid, Graphit oder Glasfasern gefüllt ist, in die Spritzgussform zur wenigstens bereichsweisen Umhüllung des Kühlungsrohrs (12), wobei das Einspritzen des gut wärmeleitfähigen Kunststoffmaterials bei einer Temperatur von 200 °C bis 400 °C und/oder einem Druck von 50 bar bis 2000 bar, insbesondere 50 bar bis 700 bar erfolgt; und
Aushärtenlassen des Kunststoffmaterials und Entnehmen des Gehäuseteils (2, 34) aus der Spritzgussform.

13. Verfahren nach Anspruch 12,
wobei das Deckelteil (34) des Kunststoffgehäuses durch die folgenden Schritte hergestellt wird:
Bereitstellen wenigstens einer Spritzgussform für das Deckelteil (34);
Einspritzen eines gut wärmeleitfähigen Kunststoffmaterials in die Spritzgussform; und
Aushärtenlassen des Kunststoffmaterials und Entnehmen des Deckelteils (34) aus der Spritzgussform.

14. Verfahren nach Anspruch 12 oder 13,
wobei das Basisteil (2) und das Deckelteil (34) des Spritzgussgehäuses unter Umschließen des als DC/DC-Wandler ausgebildeten Leistungselektronik-Bauteils miteinander verbunden, insbesondere verschraubt werden.

## Claims

1. A power electronics component of an electrified drive train of an electric motor vehicle, hybrid motor vehicle or fuel cell vehicle, which is designed as a DC/ DC converter of an electric motor vehicle, hybrid motor vehicle or fuel cell vehicle, comprising:
an injection-moulded housing comprising
a housing body made of two or more parts (2, 34), which is designed such that it encloses the power electronics component substantially completely; and
a cooling pipe (12) integrally moulded at least partially into the housing body (2, 34), which is intended for a refrigerant to flow through this cooling pipe (12) during operation;
wherein the housing body (12) is made of a plastic material with good thermal conductivity;
wherein the housing body (2, 34) made of plastic material with good thermal conductivity encloses the power electronics component substantially completely, and
wherein the cooling pipe (12) integrally moulded at least partially into the housing body (2, 34) is connected or connectable to a cooling circuit such that a refrigerant flows through this cooling pipe (12) during operation,
**characterised in that**
the housing body (12) is formed from a plastic material with good thermal conductivity, from polyamide(s) (PA) or from polycarbonate(s) (PC), which is filled with a metallic filler, namely copper or aluminium, or with a ceramic or mineral filler, namely boron nitride, graphite or glass fibres and
**in that** the cooling pipe (12) that is at least partially integrally moulded into the housing body (2, 34) is made of an aluminium alloy of the 3000 series, the 5000 series, the 6000 series or the 9000 series, or of a copper alloy of CuNi10Fe1Mn or CuNi30Mn1Fe.

2. The power electronics component according to claim 1,
wherein the tensile strength of the plastic material with good thermal conductivity of the housing body (2, 34) is in the range of 20 MPa to 250 MPa; and/or
wherein the thermal conductivity of the plastic material with good thermal conductivity of the housing body (2, 34) is in the range of 0.8 W/mK to 50 W/mK, in particular 0.8 W/mK to 30 W/mK; and/or
wherein the plastic material with good thermal conductivity of the housing body (2, 34) has a density of 1.0 g/cm³ to 5.0 g/cm³.

3. The power electronics component according to claim 1 or 2,
wherein the wall thickness of the housing body (2, 34) is in the range of 1 to 4 mm.

4. The power electronics component according to any of the preceding claims,
wherein the metallic, ceramic or mineral filler is formed in particular as a plurality of particles distributed in the plastic material with good thermal conductivity, which particles have in particular a diameter/length of 1 µm to 0.3 mm; and/or
wherein the metallic, ceramic or mineral filler in particular makes up a percentage of 5 to 80%, in particular 5 to 40%, with respect to the plastic material with good thermal conductivity.

5. The power electronics component according to any of the preceding claims, wherein the housing body (2, 34) comprises a base part (2) and a cover part (34) which are screwed together and accommodate the power electronics component therebetween in precisely fitting manner.

6. The power electronics component according to claim 5,
wherein the cooling pipe (12) is injection-moulded into the base part (2) of the housing body (2, 34); and/or
wherein the cooling pipe (12) is completely injection-moulded into the base part (2) or wherein the plastic material with good thermal conductivity of the base part (2) completely surrounds the outer surface of the cooling pipe (12).

7. The power electronics component according to any of the preceding claims,
wherein the base area of the housing body (2, 34) has a substantially rectangular shape, with two short sides (4) and two long sides (6) and in particular with a central projection (8) on one long side (6); and/or
wherein the cooling pipe (12) extends over a large part of the length and the width of the base part (2).

8. The power electronics component according to any of the preceding claims,
wherein the cooling pipe (12) comprises a first pipe end (14) and a second pipe end (16); and/or
wherein the first pipe end (14) and the second pipe end (16) are each arranged on the same first longitudinal side (6) of the base part (2); and/or
wherein the cooling pipe (12) has straight pipe starting portions (18) which are respectively adjacent to the first pipe end (14) and the second pipe end (16) and which extend in the direction towards the opposite longitudinal side (6) of the base part (2), pipe bending portions (20) directed towards each other and a pipe central portion (22) connecting the two pipe bending portions (20); and/ or
wherein the pipe central portion (22) is located close to the first longitudinal side (6) of the base part (2).

9. The power electronics component according to any of the preceding claims,
wherein a plurality of heat dissipation fins (24) is integrally formed in the base part (2), in particular adjacent to the cooling pipe enclosing portions of the base part (2); and/or
wherein the heat dissipation fins (24) occupy an area of 20 to 50 % of the surface area of the base part (2); and/or
wherein heat dissipation fins (24) are arranged at the straight pipe starting portions (18), at the pipe bending portions (20) and at the pipe central portion (22), in particular on both sides of the cooling pipe (12).

10. The power electronics component according to any of the preceding claims,
wherein the length of the housing body (2, 34) is in the range between 50 and 1000 mm, in particular 50 and 400 mm, the width of the housing body (2, 34) is in the range between 50 and 1000 mm, in particular 50 and 400 mm, and the height of the housing body (2, 34) is in the range between 20 and 500 mm, in particular 20 and 200 mm; and/or
wherein the injection-moulded housing including the cooling pipe (12) integrated in the base part (2) has a mass of 100 g to 20,000 g, in particular 100 g to 1,000 g or a weight of 0.981 N to 196.2 N, in particular 0.981 N to 9.81 N, with dimensions in the range of 50 and 1000 mm or 50 mm to 400 mm in length, 50 and 1000 mm or 50 mm to 400 mm in width and 20 and 500 mm or 20 mm to 200 mm in height.

11. The power electronics component according to any of the preceding claims,
wherein the power electronics component designed as a DC/DC converter transforms the voltage down from about 1000 V to 12 V or from 48 to 12 V during operation; and/or
wherein a current of 10 A to 500 A flows in the DC/DC converter and, as a result, heating up to 50 °C to 120 °C, in particular to 50 °C to 80 °C, takes place and the heat is dissipated by the injection-moulded housing made of plastic with good thermal conductivity and having the integrated cooling pipe (12).

12. A method for manufacturing an injection-moulded housing made of plastic for a power electronics component of an electrified drive train of an electric motor vehicle, hybrid motor vehicle or fuel cell vehicle, which is designed as a DC/ DC converter, with an integrated cooling pipe (12), comprising the following steps:
providing at least one injection mould for a part of the plastic housing (2, 34), in particular for the base part (2);
positioning an empty cooling pipe made of an aluminium alloy of the 3000 series, the 5000 series, the 6000 series or the 9000 series, or a copper alloy of CuNi10Fe1Mn or CuNi30Mn1Fe (12) in the injection mould;
injecting a plastic material with good thermal conductivity, namely polyamide(s) (PA) or polycarbonate(s) (PC), which is filled with a metallic filler, namely copper or aluminium, or with a ceramic or mineral filler, namely boron nitride, graphite or glass fibres, into the injection mould for at least partially enclosing the cooling pipe (12), wherein the injection of the plastic material with good thermal conductivity takes place at a temperature of 200 °C to 400 °C and/or a pressure of 50 bar to 2000 bar, in particular 50 bar to 700 bar; and
allowing the plastic material to cure and removing the housing part (2, 34) from the injection mould.

13. The method according to claim 12,
wherein the cover part (34) of the plastic housing is manufactured by the following steps:
providing at least one injection mould for the cover part (34);
injecting a plastic material with good thermal conductivity into the injection mould; and
allowing the plastic material to cure and removing the cover part (34) from the injection mould.

14. The method according to claim 12 or 13,
wherein the base part (2) and the cover part (34) of the injection-moulded housing are connected to one another, in particular screwed together, while enclosing the power electronics component designed as a DC/DC converter.

## Revendications

1. Composant électronique de puissance d'une chaîne de transmission électrifiée d'un véhicule à moteur électrique, hybride ou à piles à combustible, conçu comme un convertisseur continu-continu d'un véhicule à moteur électrique, hybride ou à piles à combustible, comportant :
un boîtier moulé par injection comportant
un corps de boîtier en deux ou plusieurs parties (2, 34), conçu de façon à entourer à peu près complètement le composant électronique de puissance, et
un tuyau de refroidissement (12) au moins en partie moulé dans le corps de boîtier (2, 34), conçu pour qu'un réfrigérant circule à travers ce tuyau de refroidissement (12) en fonctionnement,
le corps de boîtier (12) étant fait d'un matériau de synthèse bon conducteur thermique,
le corps de boîtier (2, 34) fait d'un matériau de synthèse bon conducteur thermique entourant à peu près complètement le composant électronique de puissance, et
le tuyau de refroidissement (12) au moins en partie moulé dans le corps de boîtier (2, 34) étant ou pouvant être raccordé à un circuit de refroidissement de telle manière qu'un
réfrigérant circule dans ce tuyau de refroidissement (12) en fonctionnement,
**caractérisé en ce que**
le corps de boîtier (12) est fait d'un matériau de synthèse bon conducteur thermique, en polyamide(s) (PA) ou en polycarbonate(s) (PC), chargé avec une charge de remplissage métallique, à savoir du cuivre ou de l'aluminium, ou avec une charge de remplissage céramique ou minérale, à savoir du nitrure de bore, du graphite ou des fibres de verre, et
**en ce que** le tuyau de refroidissement (12) au moins en partie moulé dans le corps de boîtier (2, 34) est fait d'un alliage d'aluminium de la série 3000, de la série 5000, de la série 6000 ou de la série 9000 ou d'un alliage de cuivre CuNi10Fe1Mn ou CuNi30Mn1Fe.

2. Composant électronique de puissance selon la revendication 1, dans lequel la résistance à la traction du matériau de synthèse bon conducteur thermique du corps de boîtier (2, 34) se situe
dans la plage de 20 MPa à 250 MPa et/ou
dans lequel la conductibilité thermique du matériau de synthèse bon conducteur thermique du corps de boîtier (2, 34) se situe dans la plage de 0,8 W/mK à 50 W/mK, en particulier de 0,8 W/ mK à 30 W/mK et/ou
dans lequel le matériau de synthèse bon conducteur thermique du corps de boîtier (2, 34) a une masse volumique de 1,0 g/cm³ à 5,0 g/cm³.

3. Composant électronique de puissance selon la revendication 1 ou 2, dans lequel l'épaisseur de paroi du corps de boîtier (2, 34) se situe entre 1 et 4 mm.

4. Composant électronique de puissance selon l'une des revendications précédentes, dans lequel la charge de remplissage métallique, céramique ou minérale est conformée en particulier comme un grand nombre de particules réparties dans le matériau de synthèse bon conducteur thermique, ayant en particulier un diamètre/une longueur de 1 µm à 0,3 mm, et/ou dans lequel la charge de remplissage métallique, céramique ou minérale représente en particulier une part en pourcentage de 5 à 80 %, en particulier de 5 à 40 %, par rapport au matériau de synthèse bon conducteur thermique.

5. Composant électronique de puissance selon l'une des revendications précédentes, dans lequel le corps de boîtier (2, 34) comporte une partie de base (2) et une partie formant couvercle (34), qui sont vissées l'une à l'autre et reçoivent le composant électronique de puissance entre elles avec un ajustement précis.

6. Composant électronique de puissance selon la revendication 5, dans lequel le tuyau de refroidissement (12) est inclus par injection dans la partie de base (2) du corps de boîtier (2, 34) et/ou
dans lequel le tuyau de refroidissement (12) est entièrement inclus par injection dans la partie de base (2) ou dans lequel le matériau de synthèse bon conducteur thermique de la partie de base (2) entoure complètement la surface d'enveloppe du tuyau de refroidissement (12).

7. Composant électronique de puissance selon l'une des revendications précédentes, dans lequel la surface de base du corps de boîtier (2, 34) a une forme sensiblement rectangulaire, avec deux petits côtés (4) et deux grands côtés (6) et en particulier avec une saillie centrale (8) sur un grand côté (6), et/ou
dans lequel le tuyau de refroidissement (12) s'étend sur une grande partie de la longueur et de la largeur de la partie de base (2).

8. Composant électronique de puissance selon l'une des revendications précédentes, dans lequel le tuyau de refroidissement (12) comporte une première extrémité de tuyau (14) et une deuxième extrémité de tuyau (16) et/ou
dans lequel la première extrémité de tuyau (14) et la deuxième extrémité de tuyau (16) sont disposées chacune sur le même premier grand côté (6) de la partie de base (2) et/ou
dans lequel le tuyau de refroidissement (12) comporte des longueurs droites de début de tuyau (18) partant de la première extrémité de tuyau (14) et de la deuxième extrémité de tuyau (16), qui s'étendent en direction du grand côté (6) opposé de la partie de base (2), des longueurs de coude de tuyau (20) orientées l'une vers l'autre et une longueur de milieu de tuyau (22) reliant les deux longueurs de coude de tuyau (20) et/ou
la longueur de milieu de tuyau (22) se trouve près du premier grand côté (6) de la partie de base (2).

9. Composant électronique de puissance selon l'une des revendications précédentes, dans lequel un grand nombre de nervures de dissipation de chaleur (24) sont formées d'un seul tenant
dans la partie de base (2), en particulier limitrophes des zones enveloppant le tuyau de refroidissement de la partie de base (2), et/ou
dans lequel les nervures de dissipation de chaleur (24) occupent une aire de 20 à 50 % de la surface de la partie de base (2), et/ou
dans lequel des nervures de dissipation de chaleur (24) sont disposées sur les longueurs droites de début de tuyau (18), sur les longueurs de coude de tuyau (20) et sur la longueur de milieu de tuyau (22), en particulier de part et d'autre du tuyau de refroidissement (12).

10. Composant électronique de puissance selon l'une des revendications précédentes, dans lequel la longueur du corps de boîtier (2, 34) se situe entre 50 et 1000 mm, en particulier entre 50 et 400 mm, la largeur du corps de boîtier (2, 34) se situe entre 50 et 1000 mm, en particulier entre 50 et 400 mm, et la hauteur du corps de boîtier (2, 34) se situe entre 20 et 500 mm, en particulier entre 20 et 200 mm, et/ou
dans lequel le boîtier moulé par injection, y compris le tuyau de refroidissement (12) intégré dans la partie de base (2), a une masse de 100 g à 20 000 g, en particulier de 100 g à 1000 g, ou un poids de 0,981 N à 196,2 N, en particulier de 0,981 N à 9,81 N, pour des dimensions comprises entre 50 et 1000 mm ou entre 50 mm et 400 mm de longueur, entre 50 et 1000 mm ou entre 50 mm et 400 mm de largeur et entre 20 et 500 mm ou entre 20 mm et 200 mm de hauteur.

11. Composant électronique de puissance selon l'une des revendications précédentes, dans lequel le composant électronique de puissance conçu comme un convertisseur continu-continu abaisse la tension d'environ 1000 V à 12 V ou de 48 à 12 V en fonctionnement, et/ou en ce qu'un courant de 10 A à 500 A circule dans le convertisseur continu-continu et il se produit en conséquence un échauffement à 50 °C à 120 °C, en particulier à 50 °C à 80 °C, et la chaleur est évacuée par le boîtier moulé par injection fait de matériau de synthèse bon conducteur thermique avec tuyau de refroidissement (12) intégré.

12. Procédé pour la fabrication d'un boîtier en matériau de synthèse moulé par injection pour un composant électronique de puissance d'une chaîne de transmission électrifiée d'un véhicule à moteur électrique, hybride ou à piles à combustible, conçu comme un convertisseur continu-continu, avec un tuyau de refroidissement (12) intégré, comprenant les étapes suivantes :
préparation d'au moins un moule de moulage par injection pour une partie du boîtier en matériau de synthèse (2, 34), en particulier pour la partie de base (2) ;
placement d'un tuyau de refroidissement vide fait d'un alliage d'aluminium de la série 3000, de la série 5000, de la série 6000 ou de la série 9000 ou d'un alliage de cuivre CuNilOFelMn ou CuNi30Mn1Fe (12) ;
injection d'un matériau de synthèse bon conducteur thermique, à savoir de polyamide(s) (PA) ou de polycarbonate(s) (PC), chargé avec une charge de remplissage métallique, à savoir du cuivre ou de l'aluminium, ou avec une charge de remplissage céramique ou minérale, à savoir du nitrure de bore, du graphite ou des fibres de verre, dans le moule de moulage par injection pour envelopper au moins par zones le tuyau de refroidissement (12), l'injection du matériau de synthèse bon conducteur thermique étant effectuée à une température de 200 °C à 400 °C et/ou sous une pression de 50 bars à 2000 bars, en particulier de 50 bars à 700 bars, et
attente du durcissement du matériau de synthèse et retrait de la partie de boîtier (2, 34) du moule de moulage par injection.

13. Procédé selon la revendication 12, dans lequel la partie formant couvercle (34) du boîtier en matériau de synthèse est fabriquée suivant les étapes de :
préparation d'au moins un moule de moulage par injection pour la partie formant couvercle (34) ;
injection d'un matériau de synthèse bon conducteur thermique dans le moule de moulage par injection ; et
attente du durcissement du matériau de synthèse et retrait de la partie formant couvercle (34) du moule de moulage par injection.

14. Procédé selon la revendication 12 ou 13, dans lequel la partie de base (2) et la partie formant couvercle (34) du boîtier moulé par injection sont assemblées l'une avec l'autre, en particulier vissées, en entourant le composant électronique de puissance conçu comme un convertisseur continu-continu.
